# EUROPEAN PATENT SPECIFICATION

(11) **EP 4 214 835 B1**
(45) Date of publication and mention of the grant of the patent: **11.11.2026**
(21) Application number: 20789053.4
(22) Date of filing: 07.10.2020
(51) Int. Cl.: H03G 1/00, H03F 3/45

(54) **VARIABLE GAIN AMPLIFIER**
VERSTÄRKER MIT VARIABLER VERSTÄRKUNG
AMPLIFICATEUR À GAIN VARIABLE

(43) Date of publication of application: 26.07.2023
(73) Proprietor: Huawei Technologies Co., Ltd., Shenzhen, Guangdong 518129 (CN)
(72) Inventor: ROSSI, Paolo, 80992 Munich (DE); PIPINO, Alessandra, 80992 Munich (DE); ASERO, Claudio, 80992 Munich (DE)
(74) Representative: Gill Jennings & Every LLP
(86) International application number: PCT/EP2020/078075
(87) International publication number: WO 2022/073599

(56) References cited:
- EP-A1- 0 620 639
- EP-A2- 1 526 638
- EP-B1- 1 526 638
- US-A1- 2002 025 792

## Description

### TECHNICAL FIELD

The present disclosure relates generally to the field of amplifiers; and more specifically, to a variable gain amplifier used to enhance the performance of a radio frequncy (RF) or analog integrated circuit (IC) for signal data processing.

### BACKGROUND

Generally, a variable gain amplifier (VGA) is defined as an amplifier with adjustable gain. The gain of the variable gain amplifier is adjusted either through a control voltage or a control current. The variable gain amplifier is used whenever a signal amplification chain needs a gain control mechanism.

Currently, certain topologies have been proposed for the variable gain amplifier such as a conventional four-quadrant multiplier variable gain amplifier (VGA), a conventional dual stage variable gain amplifier and a conventional multi-input variable gain amplifier. Each topology of the variable gain amplifier has its own features and limitations. The conventional four-quadrant multiplier VGA includes an input stage and a quad stage (also known as a Gilbert-cell). The gain variability is provided by the quad stage which includes a group of four transistor devices (also represented as Qₐ, Q_{b}, Q'ₐ, Q'_{b}). The input stage uses a differential input voltage signal and transconductance gain of an input pair of transistors (also represented as Qᵢₙ₊ and Qᵢₙ₋) and generates a differential current signal which is further controlled by the quad stage. In this way, the quad stage provides gain variability in the current domain. However, the conventional four-quadrant multiplier variable gain amplifier manifests a limited gain range and various design issues which affect gain range precision, control voltage and noise performance. In an example of a minimum gain configuration, the gain range of the conventional four-quadrant multiplier variable gain amplifier is affected by an offset and a mismatch between quad pairs (i.e. Qₐ and Q_{b}). The reason is that each impairment of the quad pairs leads to a limited precision of the differential input current splitting ratio and consequently, into a limited precision of the gain range of the conventional four-quadrant multiplier variable gain amplifier. In order to obtain a high precision in the gain range of the conventional four-quadrant multiplier variable gain amplifier, the generation of a stable and controlled voltage is also another limitation. In another example of the maximum gain configuration, a gain reduction which is due to the current flowing into a transistor (i.e. Q_{b}), strongly degrades the noise performance of the conventional four-quadrant multiplier variable gain amplifier. In order to overcome the limitations of the conventional four-quadrant multiplier variable gain amplifier, the conventional dual stage variable gain amplifier and further the conventional multi-input variable gain amplifier have been proposed. The conventional dual stage variable gain amplifier (VGA) includes two different input stages such as a high gain input stage and a low gain input stage. The high gain input stage includes Q1p/n transistors and Re_hg as a degeneration resistor to provide a high gain. The low gain input stage includes Q2p/n transistors and Re_lg as a degeneration resistor and provides a comparatively lower gain than the high gain input stage. A plurality of transistors Q3p/n form an analog multiplier which operates in conjunction with the high gain as well as the low gain input stages. The plurality of transistors Q3p/n are driven by differential gain control signals (also represented as Vgcp_h-Vgcn_h, Vgcp_l-Vgcn_l). Depending on the differential gain control signal values, the signal currents generated by the two input stages are mixed in different proportions and provided to a load resistor (e.g. RL) and thus, the gain variability is achieved in the conventional dual stage variable gain amplifier. Similarly, the conventional multi-input variable gain amplifier includes n-weighted input stages with fixed gain which are combined with a quad stage and controlled by n voltages derived from Vcontrol. The conventional multi-input variable gain amplifier still manifests certain limitations related to gain range precision, control voltage and noise performance. In the conventional multi-input variable gain amplifier, by virtue of the multi-input stages, the overall gain range is obtained by mixing every single gain range by use of appropriate control voltages which leads to complexity and less gain precision. Moreover, a complex circuitry is required to generate multiple control voltages. From a noise perspective, the transistors in the quad stage (or the gain variable stage) create multiple paths for various noise sources (e.g. shot noise, base resistance, etc.) of the active elements to the output and results into a gain reduction. As a consequence, the gain reduction degrades the noise performance of the conventional multi-input variable gain amplifier. Thus, there exists a technical problem of an inefficient variable gain amplifier that manifests limited gain range, complexity, and poor noise performance.

EP 1526638 A2 discloses a variable gain amplifier, including a first constant current amplifier configured to generate a reference current from an input signal. It discloses a controller configured to generate a bias current and a first control signal based on control voltage. It further discloses an addition current generator configured to generate a variable current from the input signal based on the bias current, and to generate a addition current by controlling the variable current in accordance with the first control signal. It further discloses an adder configured to generate a first output signal by adding the reference current and the addition current.

US 2002/025792 A1 discloses an AGC amplifier circuit having a fixed-gain amplifier, of which the gain is not controlled by an AGC voltage, and a variable-gain amplifier, of which the gain is controlled by the AGC voltage, that are connected in parallel. It discloses that when the AGC voltage is within a predetermined voltage range, the overall gain of the AGC amplifier circuit is varied by the variable-gain amplifier; however, when the AGC voltage is outside the predetermined voltage range, the overall gain is kept constant by the fixed-gain amplifier. It further discloses that the minimum gain of the AGC amplifier circuit is set to be equal to the gain of the fixed-gain amplifier.

EP0620639A1 discloses a variable gain amplifier composed of a first voltage-to-current amplifier having a fixed gain; a second voltage-to-current amplifier having a variable gain, functioning in parallel to said first amplifier; a gain control and stabilization variable current generator; a current-to-voltage converter. It discloses that current output signals produced by said first and second amplifiers and by said variable current generator are summed and the resulting current signal is converted to a voltage signal by said converter.

Therefore, in light of the foregoing discussion, there exists a need to overcome the aforementioned drawbacks associated with conventional variable gain amplifiers.

### SUMMARY

The present disclosure seeks to provide an improved variable gain amplifier that manifests improved dynamic range of gain variability, less complexity and improved noise performance. The present disclosure seeks to provide a solution to the existing problem of an inefficient variable gain amplifier that manifests limited gain range, complexity and poor noise performance. An aim of the present disclosure is to provide a solution that overcomes at least partially the problems encountered in the prior art, and provides an improved variable gain amplifier that manifests improved dynamic range of gain variability, less complexity and improved noise performance. The invention is defined in the appended claims.

The object of the present disclosure is achieved by the solutions provided in the enclosed independent claims. Advantageous implementations of the present disclosure are further defined in the dependent claims.

In one aspect, as a general background, the present disclosure provides a variable gain amplifier for amplifying an input voltage and providing an amplified output voltage, comprising:
an input stage that includes two differential transistor pairs, the input stage being coupled to an input of the amplifier;
an output stage that includes a transistor quad and an additional pair of transistors, the output stage being coupled to an output of the amplifier, and the transistor quad including terminals to receive a gain control;
an output of a first of the differential transistor pairs of the input stage being coupled to an input of the output stage quad to provide a variable gain path, controllable by the gain control signal, between the amplifier input and the amplifier output; and
an output of the second of the differential transistor pairs of the input stage being coupled to an input of the additional transistor pair to provide a fixed gain path between the amplifier input and the amplifier output, the fixed gain path having a gain that is independent of the gain control signal.

The variable gain amplifier of the present disclosure provides a precise gain range by applying either summation or subtraction of transconductance gain of the two differential transistor pairs. The disclosed variable gain amplifier is resilient to any mismatch or impairment of the quad transistors. The precise gain range provided by the disclosed variable gain amplifier is independent of the absolute values of the gain control signal (or the control voltage). Additionally, in a case of maximum or minimum gain configurations of the variable gain amplifier, the current steering pair of transistors (i.e. the transistor quad) is completely unbalanced, having one of the two devices switched OFF. Therefore, in these configurations, the transistor quad does not contribute to the output noise and leads to a better noise performance of the variable gain amplifier. The better noise performance substantially contributes in the extension of the dynamic range of gain variability of the disclosed variable gain amplifier in comparison to a conventional four-quadrant multiplier variable gain amplifier. By virtue of the improved dynamic range of gain variability, the disclosed variable gain amplifier is suitable for use in a receiver or transmitter for wired or an optical communication system. The disclosed variable gain amplifier also finds practical application in a transceiver for wireless (e.g. mmWave) communication or an analog device with gain variability features.

In an implementation form, the amplifier input is coupled to a control terminal of each of the transistors of the second of the differential transistor pairs of the input stage.

By virtue of coupling of the amplifier input to the control terminal of each of the transistors of the second of the differential transistor pairs of the input stage, an amplification is obtained in the amplifier input.

In a further implementation form, a control terminal of one of the transistors of the first of the differential transistor pairs of the input stage is coupled to a control terminal of one of the transistors of the second of the differential transistor pairs of the input stage, and a control terminal of the other of the transistors of the first of the differential transistor pairs of the input stage is coupled to a control terminal of the other of the transistors of the second of the differential transistor pairs of the input stage.

By virtue of coupling of the control terminal of each of the transistors of the first of the differential transistor pairs of the input stage to the control terminal of each of the transistors of the second of the differential transistor pairs of the input stage, the amplifier input is also applied to each of the transistors of the first of the differential transistor pairs of the input stage.

In a further implementation form, a first current terminal of one of the transistors of the first of the differential transistor pairs of the input stage is coupled through a first pair of resistance elements to a first current terminal of the other of the transistors of the first of the differential transistor pairs of the input stage.

The coupling of the first current terminal of one of the transistors of the first of the differential transistor pairs of the input stage to the first current terminal of the other of the transistors of the first of the differential transistor pairs of the input stage through the first pair of resistance elements provides a required amount of automatic biasing for each transistor of the first differential transistor pair to operate in a common emitter configuration.

In a further implementation form, a first current terminal of one of the transistors of the second of the differential transistor pairs of the input stage is coupled through a second pair of resistance elements to a first current terminal of the other of the transistors of the second of the differential transistor pairs of the input stage.

The coupling of the first current terminal of one of the transistors of the second of the differential transistor pairs of the input stage to the first current terminal of the other of the transistors of the second of the differential transistor pairs of the input stage through the second pair of resistance elements provides a required amount of automatic biasing for each transistor of the second differential transistor pair to operate in a common emitter configuration.

In a further implementation form, a current source is connected between each pair of resistance elements.

The current source is used to maintain a constant current flow throughout the circuitry of the disclosed variable gain amplifier.

In a further implementation form, a bias voltage is arranged to be applied across control terminals of the additional pairs of transistors of the output stage.

The bias voltage applied across control terminals of the additional pairs of transistors of the output stage allows an input signal to have a large signal range.

The transistors are bipolar devices, and each of the additional pairs of transistors of the output stage has an emitter coupled to a collector of a respective one of the second of the differential transistor pairs of the input stage.

It is advantageous to have the transistors as bipolar junction transistors because they assist the variable gain amplifier to operate in a high bandwidth application. Additionally, the coupling of each transistor of the additional pairs of transistors of the output stage to each transistor of the second of the differential transistor pairs of the input stage provides a fixed gain path.

In an alternate implementation form, the transistors are field effect devices, and each of the additional pairs of transistors of the output stage has a source coupled to a drain of a respective one of the second of the differential transistor pairs of the input stage.

This is advantageous to have the transistors as field effect devices because of their infinite input impedance which further assists the variable gain amplifier to achieve a high amplification. Additionally, the coupling of each transistor of the additional pairs of transistors of the output stage to each transistor of the second of the differential transistor pairs of the input stage provides a fixed gain path.

In a further implementation form, the transistors are bipolar devices, and the collectors of the transistor quad of the output stage are coupled together in pairs, one coupled pair of collectors being coupled to the collector of one of the transistors of the additional pair of the output stage, the other coupled pair of collectors being coupled to the collector of the other of the transistors of the additional pair of the output stage.

The coupling of the collectors of the transistor quad of the output stage to the collectors of each of the transistors of the additional pair of the output stage provides the amplified output voltage at the pair of output terminals of the variable gain amplifier.

In a further implementation form, the transistors are field effect devices, and the drains of the transistor quad of the output stage are coupled together in pairs, one coupled pair of drains being coupled to the drain of one of the transistors of the additional pair of the output stage, the other coupled pair of drains being coupled to the drain of the other of the transistors of the additional pair of the output stage.

The coupling of the drains of the transistor quad of the output stage to the drains of each of the transistors of the additional pair of the output stage provides the amplified output voltage at the pair of output terminals of the variable gain amplifier.

In another aspect, as a background information, the present disclosure provides a method of controlling the gain of a variable gain amplifier that has a pair of input terminals to receive a signal to be amplified and a pair of output terminals to supply an amplified output signal. The method comprises supplying an input signal across the pair of input terminals of an input stage of the amplifier. The method further comprises amplifying the input signal using a fixed gain amplifying path between the pair of input terminals and the pair of output terminals to provide a fixed gain component of the amplified output signal at the pair of output terminals. The method further comprises amplifying the input signal using a variable gain amplifying path between the pair of input terminals and the pair of output terminals to provide a variable gain component of the amplified output signal at the pair of output terminals. The method further comprises applying varying gain control signals to an output stage of the variable gain amplifier to vary the gain of the variable gain path to dcontrol the size of the amplified output signal.

The method of this aspect achieves all the advantages and effects of the variable gain amplifier.

### BRIEF DESCRIPTION OF THE DRAWINGS

The summary above, as well as the following detailed description of illustrative embodiments, is better understood when read in conjunction with the appended drawings. For the purpose of illustrating the present disclosure, exemplary constructions of the disclosure are shown in the drawings. However, the present disclosure is not limited to specific methods and instrumentalities disclosed herein. Wherever possible, like elements have been indicated by identical numbers.

Embodiments of the present disclosure will now be described, by way of example only, with reference to the following diagrams wherein:
FIG. 1A is a circuit diagram of a variable gain amplifier, in accordance with an embodiment of the present disclosure;
FIG. 1B is a partial circuit diagram illustrating operation in the maximum gain configuration of the variable gain amplifier of FIG. 1A, in accordance with an embodiment of the present disclosure;
FIG. 1C is a partial circuit diagram illustrating operation in the minimum gain configuration of the variable gain amplifier of FIG. 1A, in accordance with an embodiment of the present disclosure;
FIG. 2 is a graphical representation that illustrates variation of an output current of a variable gain amplifier versus a gain control signal, in accordance with an embodiment of the present disclosure;
FIG. 3 is a circuit diagram of a variable gain amplifier, in accordance with another embodiment of the present disclosure; and
FIG. 4 is a flowchart of a method of controlling a gain of a variable gain amplifier, in accordance with an embodiment of the present disclosure.

In the accompanying drawings, an underlined number is employed to represent an item over which the underlined number is positioned or an item to which the underlined number is adjacent. A non-underlined number relates to an item identified by a line linking the non-underlined number to the item. When a number is non-underlined and accompanied by an associated arrow, the non-underlined number is used to identify a general item at which the arrow is pointing.

### DETAILED DESCRIPTION OF EMBODIMENTS

The following detailed description illustrates embodiments of the present disclosure and ways in which they can be implemented. Although some modes of carrying out the present disclosure have been disclosed, those skilled in the art will recognize that other embodiments for carrying out or practicing the present disclosure are also possible.

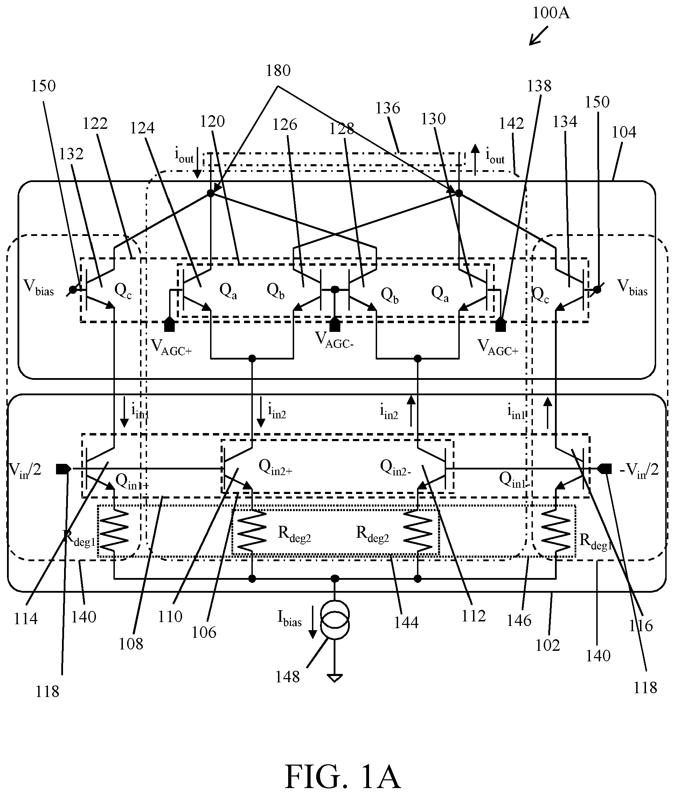

FIG. 1A is a circuit diagram of a variable gain amplifier, in accordance with an embodiment of the present disclosure. With reference to FIG. 1A, there is shown a circuit architecture of a variable gain amplifier **100A** that includes an input stage **102** and an output stage **104.** The input stage **102** includes a first differential transistor pair **106** and a second differential transistor pair **108.** The first differential transistor pair **106** includes a first transistor **110** and a second transistor **112.** The second differential transistor pair **108** includes a first transistor **114** and a second transistor **116.** The input stage **102** receives an input voltage signal **118.** The output stage **104** includes a transistor quad **120** and an additional pair of transistors **122.** The transistor quad **120** includes a first transistor **124,** a second transistor **126,** a third transistor **128** and a fourth transistor **130.** The additional pair of transistors **122** includes a first transistor **132** and a second transistor **134.** The output stage **104** provides an output voltage signal **136** across a pair of output terminals **180,** and receives a gain control signal **138** (Vagc+ to two terminals, and Vagc- to one other terminal) . There is further shown a fixed gain path **140,** a variable gain path **142,** a first pair of resistance elements **144,** a second pair of resistance elements **146,** a current source **148** and a bias voltage signal **150.** The first differential transistor pair **106,** the second differential transistor pair **108** of the input stage **102,** the transistor quad **120,** the additional pair of transistors **122** of the output stage **104,** the first pair of resistance elements **144,** the second pair of resistance elements **146** are represented by dashed sections which are used for illustration purpose only and do not form a part of circuitry.

The variable gain amplifier **100A** for amplifying an input voltage signal **118** and providing an amplified output voltage signal **136,** comprises the input stage **102** that includes two differential transistor pairs, the input stage **102** being coupled to the input **118** of the amplifier **100A.** The input stage **102** includes the first differential transistor pair **106** and the second differential transistor pair **108** which together act either in parallel or in antiparallel depending on configuration of the transistor quad **120** of the output stage **104.** The first differential transistor pair **106** includes a first transistor **110** and a second transistor **112** (also represented by Qᵢₙ₂₊ and Qᵢₙ₂₋, respectively). Each of the first transistor **110** and the second transistor **112** (i.e. Qᵢₙ₂₊ and Qᵢₙ₂₋) of the first differential transistor pair **106** is a npn transistor having three terminals namely, base, emitter and collector. Similarly, the first transistor **114** and the second transistor **116** (also represented by Qᵢₙ₁₊ and Qᵢₙ₁₋, respectively) of the second differential transistor pair **108** are npn transistors having three terminals namely, base, emitter and collector, respectively. The input voltage signal **118** (also represented by Vᵢₙ) is applied to the input stage **102.** In an implementation, the input voltage signal **118** (i.e. Vᵢₙ) is an alternating voltage signal having a positive amplitude (e.g. V_{in/2}) and a negative amplitude (e.g. -V_{in/2}). The positive amplitude (i.e. V_{in/2}) is applied to the base terminals of the first transistors **110** and **114** of the two differential transistor pairs that is the first differential transistor pair **106** and the second differential transistor pair **108.** Similarly, the negative amplitude (i.e. -V_{in/2}) is applied to the base terminals of the second transistors **112** and **116** of the two differential transistor pairs that is the first differential transistor pair **106** and the second differential transistor pair **108.**

The variable gain amplifier **100A** further comprises the output stage **104** that includes the transistor quad **120** and the additional pair of transistors **122,** the output stage **104** being coupled to the output **136** of the amplifier **100A,** and the transistor quad **120** including terminals to receive the gain control signal **138.** The transistor quad **120** includes a current steering section made by the first transistor **124,** the second transistor **126,** the third transistor **128** and the fourth transistor **130.** The first transistor **124** and the fourth transistor **130** (also represented by Qₐ), the second transistor **126** and the third transistor **128** (also represented by Q_{b}) act in conjunction with the additional transistor pair **122** to provide a fixed input-to-output path. The additional pair of transistors **122** includes the first transistor **132** and the second transistor **134** (also represented by Q_{c}). In this way, the output stage **104** becomes a six devices stage and each transistor of the transistor quad **120** and the additional pair of transistors **122** is a npn transistor having three terminals namely, base, emitter and collector. The output stage **104** receives a gain control signal **138** (also represented by V_{AGC}). The gain control signal **138** with positive part (e.g. V_{AGC+}) is applied to the base terminals of the first transistor **124** and the fourth transistor **130** (i.e. Qₐ). Similarly, the gain control signal **138** with negative part (e.g. V_{AGC-}) is applied to the base terminals of the second transistor **126** and the third transistor **128** (i.e. Q_{b}). The output stage **104** provides an amplified output voltage signal **136.**

In the variable gain amplifier **100A** the output of the first of the differential transistor pairs of the input stage **102** is coupled to an input of the output stage quad **120** to provide a variable gain path **142,** controllable by the gain control signal **138,** between the amplifier input **118** and the amplifier output **136.** The coupling of the output of the first differential transistor pair **106** (i.e. Qᵢₙ₂₊ and Qᵢₙ₂₋) of the input stage **102** as an input to the transistor quad **120** (i.e. Qₐ and Q_{b}) of the output stage **104,** provides the variable gain path **142** which is controlled by the gain control signal **138** (i.e. V_{AGC}). The variable gain path **142** provides a current contribution which is weighted by the gain control signal **138** (i.e. V_{AGC}) to the output. The current contribution provided by the variable gain path **142** is represented by the equation (equation 1) ${i}_{in 2} = \frac{{g}_{m 2}}{1 + {g}_{m 2} {R}_{deg 2}} {V}_{in}$ (1)

Where, *i*_{*i*n2} is the current contribution provided by the variable gain path **142,** *g*_{*m*2} is a transconductance gain of the first differential transistor pair **106** (i.e. Qᵢₙ₂₊ and Qᵢₙ₂₋), *R*_{*deg*2} is degeneration resistors pair such as the first pair of resistance elements **144** of the first differential transistor pair **106** and *Vᵢₙ* is the input voltage signal **118.**

In the variable gain amplifier **100A** the output of the second of the differential transistor pairs of the input stage **102** is coupled to an input of the additional transistor pair **122** to provide a fixed gain path **140** between the amplifier input **118** and the amplifier output **136,** the fixed gain path **140** having a gain that is independent of the gain control signal **138.** The coupling of the output of the second differential transistor pair **108** (i.e. Qᵢₙ₁₊ and Qᵢₙ₁₋) of the input stage **102** as an input to the additional transistor pair **122** (i.e. Q_{c}) of the output stage **104,** provides the fixed gain path **140.** The fixed gain path **140** provides a current contribution which is independent of the gain control signal **138** (i.e. V_{AGC}) to the output. The current contribution provided by the fixed gain path **140** is represented by the equation (equation 2) ${i}_{in 1} = \frac{{g}_{m 1}}{1 + {g}_{m 1} {R}_{deg 1}} {V}_{in}$ (2)

Where, *i*_{*in*1} is the current contribution provided by the fixed gain path **140,** *g*_{*m*1} is a transconductance gain of the second differential transistor pair **108** (i.e. Qᵢₙ₁₊ and Qᵢₙ₁₋), *R*_{*deg*1} is degeneration resistors pair such as the second pair of resistance elements **146** of the second differential transistor pair **108** and *Vᵢₙ* is the input voltage signal **118.**

In accordance with an embodiment, the amplifier input **118** is coupled to a control terminal (base) of each of the transistors of the second of the differential transistor pairs of the input stage **102.** In an implementation, the input voltage signal **118** (i.e. Vᵢₙ) is an alternating voltage signal having a positive amplitude (e.g. V_{in/2}) and a negative amplitude (e.g. -V_{in/2}). The positive amplitude (i.e. V_{in/2}) is applied to the control terminal (base) of the first transistor **114** (i.e. Qᵢₙ₁₊) of the second differential transistor pair **108** of the input stage **102.** Similarly, the negative amplitude (i.e. -V_{in/2}) is applied to the control terminal (base) of the second transistor **116** (i.e. Qᵢₙ₁₋) of the second differential transistor pair **108** of the input stage **102.**

In accordance with an embodiment, a control terminal (base) of one of the transistors of the first **106** of the differential transistor pairs of the input stage **102** is coupled to the control terminal (base) of one of the transistors of the second **108** of the differential transistor pairs of the input stage **102,** and the control terminal (base) of the other of the transistors of the first of the differential transistor pairs of the input stage **102** is coupled to a control terminal (base) of the other of the transistors of the second of the differential transistor pairs of the input stage **102.** In this embodiment, the control terminal (i.e. the base terminal) of the first transistor **110** (i.e. Qᵢₙ₂₊) of the first differential transistor pair **106** is coupled to the control terminal (i.e. the base terminal) of the first transistor **114** (i.e. Qᵢₙ₁₊) of the second differential transistor pair **108.** Similarly, the control terminal (i.e. the base terminal) of the second transistor **112** (i.e. Qᵢₙ₂₋) of the first differential transistor pair **106** is coupled to the control terminal (i.e. the base terminal) of the second transistor **116** (i.e. Qᵢₙ₁₋) of the second differential transistor pair **108.** By virtue of the coupling between the first and the second transistors of the two differential transistor pairs, the input voltage signal **118** is applied to the bases of the first transistor **110** and the second transistor **112** of the first differential transistor pair **106, and** to the bases of first transistor **114** and the second transistor **116** of the second differential transistor pair **108.**

In accordance with an embodiment, a first current terminal (emitter) of one of the transistors of the first of the differential transistor pairs of the input stage **102** is coupled through the first pair of resistance elements **144** to a first current terminal (emitter) of the other of the transistors of the first of the differential transistor pairs of the input stage **102.** The first current terminal (i.e. the emitter terminal) of the first transistor **110** (i.e. Qᵢₙ₂₊) of the first differential transistor pair **106** of the input stage **102** is coupled to the first current terminal (i.e. the emitter terminal) of the second transistor **112** (i.e. Qᵢₙ₂₋) of the first differential transistor pair **106** of the input stage **102** through the first pair of resistance elements **144** (also represented by R_{deg2}). In another embodiment, the first current terminal (i.e. the emitter terminal) of the first transistor **110** (i.e. Qᵢₙ₂₊) of the first differential transistor pair **106** of the input stage **102** is directly coupled to the first current terminal (i.e. the emitter terminal) of the second transistor **112** (i.e. Qᵢₙ₂₋) of the first differential transistor pair **106** of the input stage **102** in absence of the first pair of resistance elements **144** (i.e. R_{deg2}).

In accordance with an embodiment, a first current terminal of one of the transistors of the second of the differential transistor pairs of the input stage **102** is coupled through the second pair of resistance elements **146** to a first current terminal of the other of the transistors of the second of the differential transistor pairs of the input stage **102.** The first current terminal (i.e. the emitter terminal) of the first transistor **114** (i.e. Qᵢₙ₁₊) of the second differential transistor pair **108** of the input stage **102** is coupled to the first current terminal (i.e. the emitter terminal) of the second transistor **116** (i.e. Qᵢₙ₁₋) of the second differential transistor pair **108** of the input stage **102** through the second pair of resistance elements **146** (also represented by R_{deg1}). In another embodiment, the first current terminal (i.e. the emitter terminal) of the first transistor **114** (i.e. Qᵢₙ₁₊) of the second differential transistor pair **108** of the input stage **102** is directly coupled to the first current terminal (i.e. the emitter terminal) of the second transistor **116** (i.e. Qᵢₙ₁₋) of the second differential transistor pair **108** of the input stage **102** in absence of the second pair of resistance elements **146** (i.e. R_{deg1}).

In accordance with an embodiment, the current source **148** is connected between each pair of resistance elements. The current source **148** is connected between the first pair of resistance elements **144** (i.e. R_{deg2}) and the second pair of resistance elements **146** (i.e. R_{deg1}) of the input stage **102** to maintain a constant current throughout the variable gain amplifier **100A.** The current source **148** may also be referred to as a constant current source.

In accordance with an embodiment, the bias voltage **150** is arranged to be applied across control terminals of the additional pairs of transistors **122** of the output stage **104.** The bias voltage **150** (also represented by V_{bias}) is applied to the control terminals (i.e. the base terminals) of the first transistor **132** (i.e. Q_{c}) and the second transistor **134** (i.e. Q_{c}), respectively, of the additional pairs of transistors **122** of the output stage **104.**

In accordance with an embodiment, the transistors are bipolar devices, and each of the additional pairs of transistors **122** of the output stage **104** has an emitter coupled to a collector of a respective one of the second of the differential transistor pairs of the input stage **102.** In this embodiment, each transistor is a bipolar junction transistor (BJT) or a bipolar device having three terminals namely, a base, an emitter and a collector, respectively. The emitter terminals of each of the first transistor **132** (i.e. Q_{c}) and the second transistor **134** (i.e. Q_{c}) of the additional pairs of transistors **122** of the output stage **104** are coupled to the collector terminals of each of the first transistor **114** (i.e. Qᵢₙ₁₊) and the second transistor **116** (i.e. Qᵢₙ₁₋), respectively, of the second differential transistor pair **108** of the input stage **102.**

In accordance with an embodiment, the transistors are field effect devices, and each of the additional pairs of transistors **122** of the output stage **104** has a source coupled to a drain of a respective one of the second of the differential transistor pairs of the input stage **102.** In another embodiment, each transistor is a field effect transistor (FET) or a field effect device. The field effect transistor (FET) is either a junction field effect transistor (JFET) or a metal oxide semiconductor field effect transistor (MOSFET). The field effect transistor (FET) is a three terminal device having a gate, a source and a drain terminal. The source terminals of each of the first transistor **132** (i.e. Q_{c}) and the second transistor **134** (i.e. Q_{c}) of the additional pairs of transistors **122** of the output stage **104** are coupled to the drain terminals of each of the first transistor **114** (i.e. Qᵢₙ₁₊) and the second transistor **116** (i.e. Qᵢₙ₁₋), respectively, of the second differential transistor pair **108** of the input stage **102.**

In accordance with an embodiment, the transistors are bipolar devices, and the collectors of the transistor quad **120** of the output stage **104** are coupled together in pairs, one coupled pair of collectors being coupled to the collector of one of the transistors of the additional pair **122** of the output stage **104,** the other coupled pair of collectors being coupled to the collector of the other of the transistors of the additional pair **122** of the output stage **104.** The transistors of the transistor quad **120** and the additional pair of transistors **122** of the output stage **104** are coupled together. For example, the collector terminals of the first transistor **124** (i.e. Qₐ) and the third transistor **128** (i.e. Q_{b}) of the transistor quad **120** are coupled together and further coupled to the collector terminal of the first transistor **132** (i.e. Q_{c}) of the additional pair of transistors **122** of the output stage **104.** Similarly, the collector terminals of the second transistor **126** (i.e. Q_{b}) and the fourth transistor **130** (i.e. Qₐ) of the transistor quad **120** are coupled together and further coupled to the collector terminal of the second transistor **134** (i.e. Q_{c}) of the additional pair of transistors **122** of the output stage **104.**

In accordance with an embodiment, the transistors are field effect devices, and the drains of the transistor quad **120** of the output stage **104** are coupled together in pairs, one coupled pair of drains being coupled to the drain of one of the transistors of the additional pair **122** of the output stage **104,** the other coupled pair of drains being coupled to the drain of the other of the transistors of the additional pair **122** of the output stage **104.** In another embodiment, each transistor of the transistor quad **120** and the additional pair of transistors **122** of the output stage **104** is a field effect deivce. The transistors of the transistor quad **120** and the additional pair of transistors **122** of the output stage **104** are coupled together. For example, the drain terminals of the first transistor **124** (i.e. Qₐ) and the third transistor **128** (i.e. Q_{b}) of the transistor quad **120** are coupled together and further coupled to the drain terminal of the first transistor **132** (i.e. Q_{c}) of the additional pair of transistors **122** of the output stage **104.** Similarly, the drain terminals of the second transistor **126** (i.e. Q_{b}) and the fourth transistor **130** (i.e. Qₐ) of the transistor quad **120** are coupled together and further coupled to the drain terminal of the second transistor **134** (i.e. Q_{c}) of the additional pair of transistors **122** of the output stage **104.**

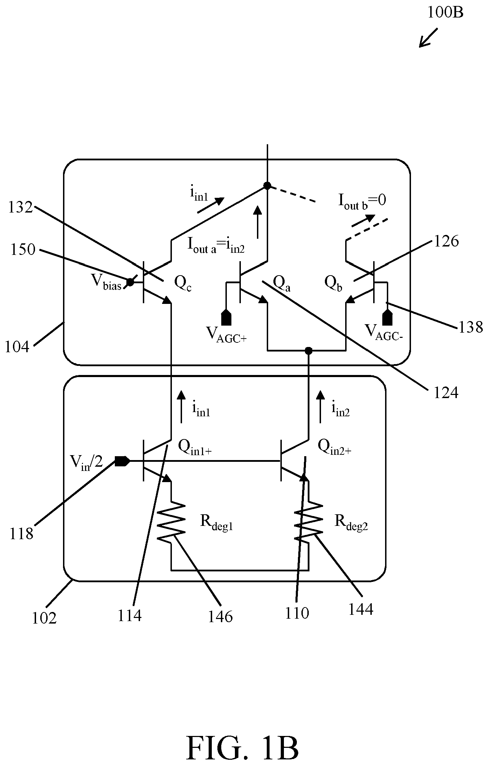

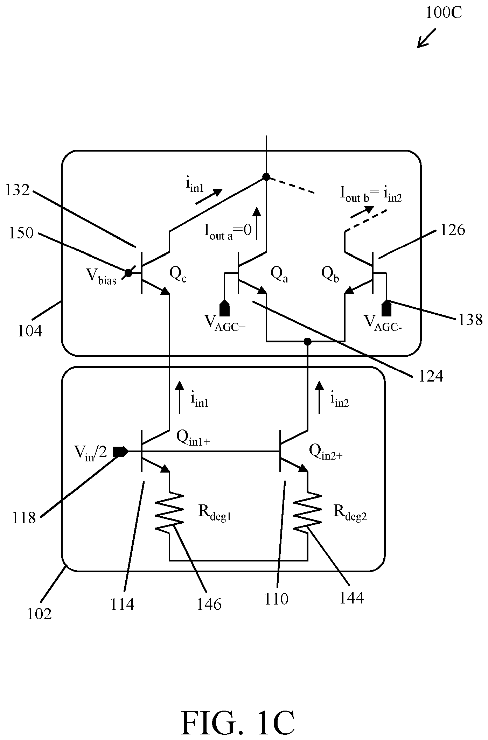

Thus, as the variable gain amplifier **100A** includes the pairing of the input stage **102** with the transistor quad **120** and the additional pair of transistors **122** of the output stage **104,** therefore, the gain variability is obtained as a combination of the variable gain path **142** and the fixed gain path **140.** The gain variability of the variable gain amplifier **100A** ranges from a maximum value to a minimum value which is illustrated, for example, in FIGs. 1B and 1C respectively. In this way, the variable gain amplifier **100A** provides an improved dynamic range of the gain variability in comparison to a conventional four-quadrant multiplier variable gain amplifier. Additionally, the variable gain amplifier **100A** provides a precise gain range by applying summation or subtraction of transconductance gains of the two differential transistor pairs of the input stage **102.** The variable gain amplifier **100A** is resilient to any mismatch or impairment of the quad transistors (i.e. Qₐ and Q_{b}). The precise gain range provided by the variable gain amplifier **100A** is independent of the absolute values of the gain control signal signal **138** (i.e. V_{AGC}). Additionally, in a case of maximum or minimum gain configurations of the variable gain amplifier **100A,** the current steering pair of transistors (i.e. the transistor quad **120)** is completely unbalanced, having one of the two devices (i.e. Qₐ and Q_{b}) switched OFF. Therefore, in these configurations, the transistor quad **120** does not contribute to the output noise and leads to a better noise performance of the variable gain amplifier **100A.** The better noise performance substantially contributes in the extension of the dynamic range of gain variability of the variable gain amplifier **100A.** Thus, the variable gain amplifier **100A** is suitable for use in a wired or an optical communication system. The variable gain amplifier **100A** is potentially used in receivers (e.g. transimpedance amplifiers (TIAs)) and transmitters (e.g. drivers) for the wired or the optical communication system. Additionally, the variable gain amplifier **100A** finds use in transceivers for wireless or millimetre wave (mmW) applications, analog devices including gain variability features and the like.

FIG. 1B is a partial circuit diagram illustrating operation in the maximum gain configuration of the variable gain amplifier of FIG. 1A, in accordance with an embodiment of the present disclosure. FIG. 1B is described in conjunction with elements from FIG. 1A. With reference to FIG. 1B, there is shown a circuit architecture **100B** of a maximum gain configuration of the variable gain amplifier **100A** of FIG. 1A.

The maximum gain of the variable gain amplifier **100A** is represented by the following equation (equation 3) ${Gain}_{max} = \frac{{g}_{m 1}}{1 + {g}_{m 1} {R}_{deg 1}} + \frac{{g}_{m 2}}{1 + {g}_{m 2} {R}_{deg 2}}$ (3)

In the maximum gain configuration of the variable gain amplifier **100A,** the second transistor **126** and the third transistor **128** (i.e. Q_{b}) of the transistor quad **120** of the output stage **104** are completely off and the signal current iᵢₙ₂ generated by the variable gain path **142** flows through the first transistor **124** and the fourth transistor **130** (i.e. Qₐ). An output current (also represented by I_{out a}) of the variable gain amplifier **100A** corresponds to the signal current iᵢₙ₂ flowing through the first transistor **124** and the fourth transistor **130** (i.e. Qₐ) according to the equation (equation 4) ${I}_{out a} = {i}_{in 2}$ (4)

The second transistor **126** and the third transistor **128** (i.e. Q_{b}) of the transistor quad **120** are connected to the low value of the gain control signal **138** (i.e. V_{AGC-}). Therefore, when the gain control signal **138** (i.e. V_{AGC+}) is high, the first transistor **124** and the fourth transistor **130** (i.e. Qₐ) are in ON state, at the same time, the second transistor **126** and the third transistor **128** (i.e. Q_{b}) are in OFF state by virtue of connection to the low value of the gain control signal **138** (i.e. V_{AGC-}). Therefore, a null output current (also represented by I_{out b}) flows through the second transistor **126** and the third transistor **128** (i.e. Q_{b}) according to the equation (equation 5) ${I}_{out b} = 0$ (5)

FIG. 1C is a circuit diagram illustrating operation in the minimum gain configuration of the variable gain amplifier of FIG. 1A, in accordance with an embodiment of the present disclosure. FIG. 1C is described in conjunction with elements from FIGs. 1A and 1B. With reference to FIG. 1C, there is shown the effective circuit architecture **100C** of the minimum gain condition of the variable gain amplifier **100A** of FIG. 1A.

The minimum gain of the variable gain amplifier **100A** is represented by the following equation (equation 6) ${Gain}_{min} = \frac{{g}_{m 1}}{1 + {g}_{m 1} {R}_{deg 1}} - \frac{{g}_{m 2}}{1 + {g}_{m 2} {R}_{deg 2}}$ (6)

In the minimum gain configuration of the variable gain amplifier **100A,** the first transistor **124** and the fourth transistor **130** (i.e. Qₐ) of the transistor quad **120** of the output stage **104** are completely off and the signal current iᵢₙ₂ generated by the variable gain path **142** flows through the second transistor **126** and the third transistor **128** (i.e. Q_{b}). An output current (also represented by I_{out b}) of the variable gain amplifier **100A** corresponds to the signal current iᵢₙ₂ flowing through the second transistor **126** and the third transistor **128** (i.e. Q_{b}) according to the equation (equation 7) ${I}_{out b} = {i}_{in 2}$ (7)

However, a null output current (also represented by I_{out a}) flows through the first transistor **124** and the fourth transistor **130** (i.e. Qₐ) according to the equation (equation 8) ${I}_{out a} = 0$ (8)

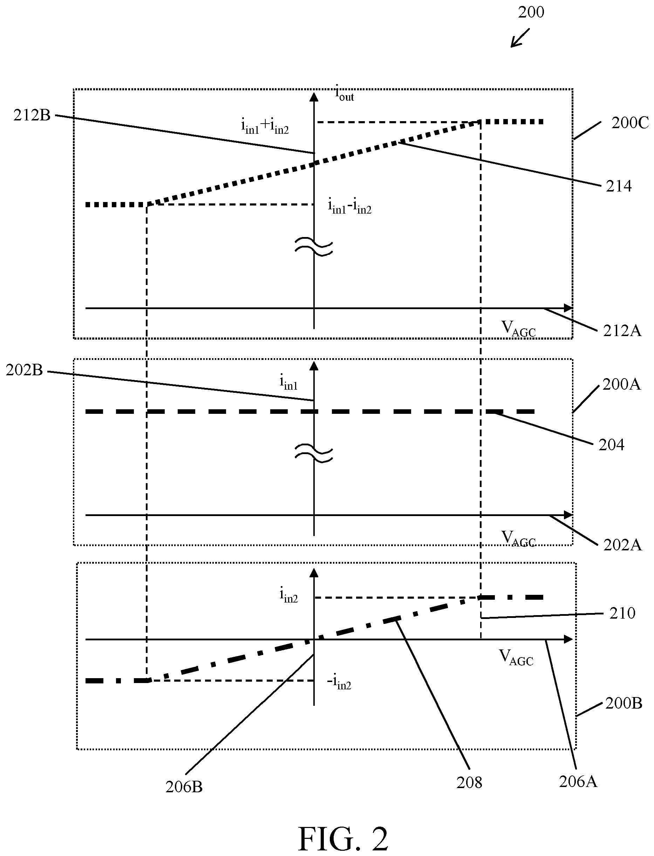

FIG. 2 is a graphical representation that illustrates variation of an output current of a variable gain amplifier with respect to a gain control signal, in accordance with an embodiment of the present disclosure. FIG. 2 is described in conjunction with elements from FIGs. 1A, 1B, and 1C. With reference to FIG. 2, there is shown a graphical representation **200** that includes a first graphical representation **200A,** a second graphical representation **200B** and a third graphical representation **200C.**

The first graphical representation **200A** includes an X-axis **202A** that represents a gain control signal such as the gain control signal **138** of FIG. 1A (i.e. V_{AGC}) and a Y-axis **202B** that represents a current contribution provided by the fixed gain path **140** of FIG. 1A. In the first graphical representation **200A,** a first line **204** represents that the current contribution (i.e. iᵢₙ₁) provided by the fixed gain path **140** is independent of the gain control signal **138** (i.e. V_{AGC}). The current contribution (i.e. iᵢₙ₁) is independent of the positive as well as negative values of the gain control signal **138** (i.e. V_{AGC}).

The second graphical representation **200B** includes an X-axis **206A** that represents a gain control signal such as the gain control signal **138** of FIG. 1A (i.e. V_{AGC}) and a Y-axis **206B** that represents a current contribution provided by the variable gain path **142** of FIG. 1A. In the second graphical representation **200B,** a first line **208** represents that the current contribution (i.e. iᵢₙ₂) provided by the variable gain path **142** is weighted by the gain control signal **138** (i.e. V_{AGC}) to the output. The current contribution (i.e. iᵢₙ₂) provided by the variable gain path **142** varies linearly with respect to the gain control signal **138** (i.e. V_{AGC}) but after a certain point which is represented by a second line **210,** the current contribution (i.e. iᵢₙ₂) become saturated with respect to the gain control signal **138** (i.e. V_{AGC}). The current contribution (i.e. iᵢₙ₂) provided by the variable gain path **142** follows the same behaviour for the positive as well as negative values of the gain control signal **138** (i.e. V_{AGC}).

The third graphical representation **200C** includes an X-axis **212A** that represents the gain control signal **138** of FIG. 1A (i.e. V_{AGC}) and a Y-axis **212B** that represents a total output current (also represented by iₒᵤₜ) of the variable gain amplifier **100A.** In the third graphical representation **200C,** a first line **214** represents that the total output current (i.e. iₒᵤₜ) of the variable gain amplifier **100A** varies linearly with respect to the gain control signal **138** (i.e. V_{AGC}) upto a certain point. The total output current (i.e. iₒᵤₜ) is represented as a sum or difference of the current distributions (i.e. iᵢₙ₁, iᵢₙ₂) provided by the fixed gain path **140** and the variable gain path **142,** respectively. The total output current (i.e. iₒᵤₜ) of the variable gain path **142** varies linearly with respect to the gain control signal **138** (i.e. V_{AGC}) but after a certain point which is represented by the second line **210,** the total output current (i.e. iₒᵤₜ) become saturated with respect to the gain control signal **138** (i.e. V_{AGC}).

In this way, the graphical representation **200** illustrates the variation of the total output current (i.e. iₒᵤₜ) as a function of the gain control signal **138** (i.e. V_{AGC}). By considering the equations (equation 1 and equation 2) of the current contributions (i.e. iᵢₙ₁, iᵢₙ₂) provided by the fixed gain path **140** and the variable gain path **142,** it is demonstrated that the gain of the variable gain amplifier **100A** ranges from the maximum value to the minimum value as represented by the equations (equation 3 and equation 6).

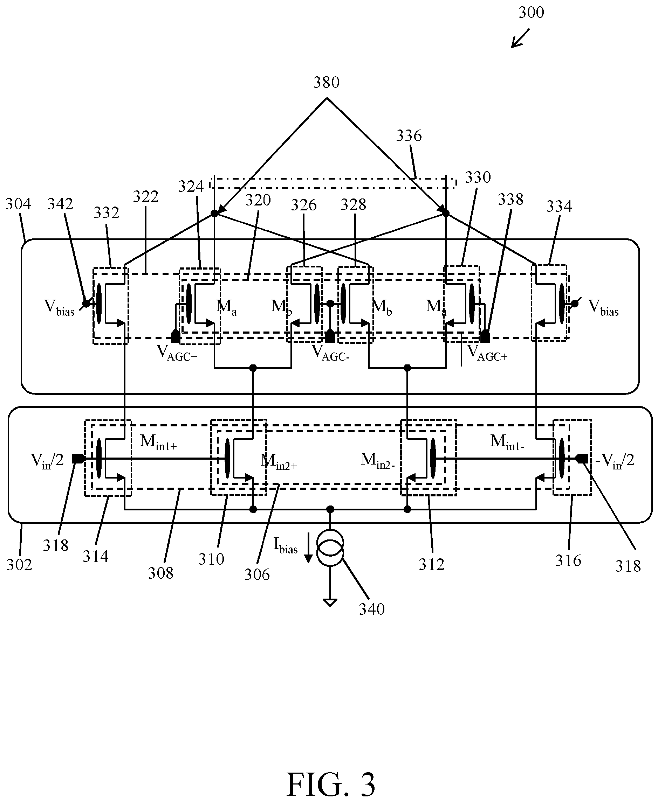

FIG. 3 is a circuit diagram of a variable gain amplifier, in accordance with another embodiment of the present disclosure. FIG. 3 is described in conjunction with elements from FIG. 1A. With reference to FIG. 3, there is shown a circuit architecture of a variable gain amplifier **300** that includes an input stage **302** and an output stage **304.** The input stage **302** includes a first differential transistor pair **306** and a second differential transistor pair **308.** The first differential transistor pair **306** includes a first transistor **310** and a second transistor **312.** The second differential transistor pair **308** includes a first transistor **314** and a second transistor **316.** The input stage **302** further includes an input voltage signal **318.** The output stage **304** includes a transistor quad **320** and an additional pair of transistors **322.** The transistor quad **320** includes a first transistor **324,** a second transistor **326,** a third transistor **328** and a fourth transistor **330.** The additional pair of transistors **322** includes a first transistor **332** and a second transistor **334.** The output stage **304** further includes an output voltage signal **336** and a gain control signal **338.** There is further shown a current source **340** and a bias voltage signal **342.** The first differential transistor pair **306,** the second differential transistor pair **308** of the input stage **302,** the transistor quad **320,** the additional pair of transistors **322** of the output stage **304** are represented by dashed sections which are used for illustration purpose only and do not form a part of circuitry.

The variable gain amplifier **300** corresponds to the variable gain amplifier **100A** except that, in the variable gain amplifier **300,** each transistor (e.g. Mᵢₙ₂₊, Mᵢₙ₂₋, Mᵢₙ₁₊, Mᵢₙ₁₋, Mₐ, M_{b}, M_{c}) of the input stage **302** and the output stage **304** is a complementary metal oxide semiconductor (CMOS) transistor having three terminals namely, a gate, a source, and a drain, respectively. However, in the variable gain amplifier **100A** (of FIG. 1A), each transistor (e.g. Qᵢₙ₂₊, Qᵢₙ₂₋, Qᵢₙ₁₊, Qᵢₙ₁₋, Qₐ, Q_{b}, Q_{c}) of the input stage **102** and the output stage **104** is bipolar junction transistor (BJT) having three terminals namely, a base, an emitter and a collector, respectively. The variable gain amplifier **300** is an alternative implementation of the variable gain amplifier **100A** (of FIG. 1A). In the variable gain amplifier **300,** each transistor (e.g. Mᵢₙ₂₊, Mᵢₙ₂₋, Mᵢₙ₁₊, Mᵢₙ₁₋, Mₐ, M_{b}, M_{c}) being a CMOS transistor has an infinite input impedance which results in a high amplification of the input voltage signal **318.** A complementary metal oxide semiconductor (CMOS) transistor includes a P-channel (PMOS) and an N-channel (NMOS) transistors. The term MOS in CMOS is an abbreviation of MOSFET (i.e. metal oxide semiconductor field effect transistor). The P-channel MOSFET includes P-type source and drain both of which are diffused on a N-type substrate and majority charge carriers are holes. Similarly, the N-channel MOSFET includes N-type source and drain both of which are diffused on a P-type substrate and majority charge carriers are electrons. In another embodiment, each transistor (e.g. Mᵢₙ₂₊, Mᵢₙ₂₋, Mᵢₙ₁₊, Mᵢₙ₁₋, Mₐ, M_{b}, M_{c}) of the input stage **302** and the output stage **304** is a bipolar CMOS (BiCMOS) transistor having three terminals namely, a gate, a source, and a drain, respectively.

Working and connections of each transistor (e.g. Mᵢₙ₂₊, Mᵢₙ₂₋, Mᵢₙ₁₊, Mᵢₙ₁₋, Mₐ, M_{b}, M_{c}) of the input stage **302** and the output stage **304** of the variable gain amplifier **300** is same that has been described in detail, for example, in FIG. 1A and hence omitted here for the sake of brevity.

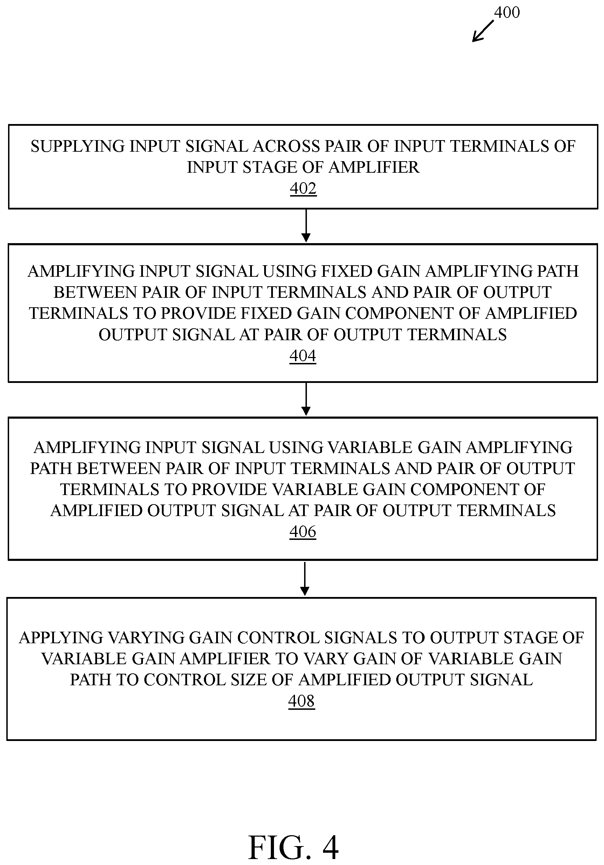

FIG. 4 is a flowchart of a method of controlling a gain of a variable gain amplifier, in accordance with an embodiment of the present disclosure. FIG. 4 is described in conjunction with elements from FIGs. 1A, and 3. With reference to FIG. 4, there is shown a method **400** of controlling a gain of a variable gain amplifier such as the variable gain amplifier **100A** (of FIG. 1A) or the amplifier **300A** (of Fig. 3. The method **400** is executed, for example, by the variable gain amplifier **100A or 300A.** The method **400** includes steps **402** to **408.**

The variable gain amplifier **100A** includes a pair of input terminals to receive a signal such as the input voltage signal **118** to be amplified and a pair of output terminals **180** to supply an amplified output signal such as the output voltage signal **136.**

At step **402,** the method **400** comprises supplying an input signal across the pair of input terminals of an input stage of the amplifier. In the variable gain amplifier **100A,** the first differential transistor pair **106** and the second differential transistor pair **108** of the input stage **102** are configured to receive the input signal such as the input voltage signal **118.**

At step **404,** the method **400** further comprises amplifying the input signal using a fixed gain amplifying path between the pair of input terminals and the pair of output terminals to provide a fixed gain component of the amplified output signal at the pair of output terminals. In the variable gain amplifier **100A,** the second differential transistor pair **108** of the input stage **102** is coupled to the additional pair of transistors **122** of the output stage **104** to provide the fixed gain path **140.** The fixed gain path **140** provides the current contribution (i.e. iᵢₙ₁) in the amplified ouput signal such as the output voltage signal **136.**

At step **406,** the method **400** further comprises amplifying the input signal using a variable gain amplifying path between the pair of input terminals and the pair of output terminals **180** to provide a variable gain component of the amplified output signal at the pair of output terminals. In the variable gain amplifier **100A,** the first differential transistor pair **106** of the input stage **102** is coupled to the transistor quad **120** of the output stage **104** to provide the variable gain path **142.** The variable gain path **142** provides the current contribution (i.e. iᵢₙ₂) in the amplified ouput signal such as the output voltage signal **136.**

At step **408,** the method **400** further comprises applying varying gain control signals to an output stage of the variable gain amplifier to vary the gain of the variable gain path to control the size of the amplified output signal. In the variable gain amplifier **100A,** the output stage **104** includes the gain control signal **138** which is used to vary the gain of the variable gain path **142** and further controls the amplified output signal **136.**

The steps **402** to **408** are only illustrative and other alternatives can also be provided where one or more steps are added, one or more steps are removed, or one or more steps are provided in a different sequence without departing from the scope of the claims herein.

## Claims

1. A variable gain amplifier (100A) for amplifying an input voltage (118) and providing an amplified output voltage (136), comprising:
an input stage (102) that includes two differential transistor pairs (106, 108), the input stage (102) being coupled to an input (118) of the amplifier (100A);
an output stage (104) that includes a transistor quad (120) and an additional pair of transistors (122), the output stage (104) being coupled to an output (180) of the amplifier (100A), and the transistor quad (120) including terminals to receive a gain control signal (138);
an output of a first (106) of the differential transistor pairs of the input stage (102) being coupled to an input of the output stage quad (120) to provide a variable gain path (142), controllable by the gain control signal (138), between the amplifier input (118) and the amplifier output (136); and
an output of the second (108) of the differential transistor pairs of the input stage (102) being coupled to an input of the additional transistor pair (122) to provide a fixed gain path (140) between the amplifier input (118) and the amplifier output (180), the fixed gain path (140) having a gain that is independent of the gain control signal (138),
wherein:
the transistors are bipolar devices; and
the transistors of the additional pair of transistors (122) of the output stage (104) has an emitter coupled to a collector of a respective one of the second of the differential transistor pairs of the input stage (102).

2. The variable gain amplifier (100A) of claim 1, wherein the transistors are bipolar devices, and the collectors of the transistor quad (120) of the output stage (104) are coupled together in pairs, one coupled pair of collectors being coupled to the collector of one of the transistors of the additional pair (122) of the output stage (104), the other coupled pair of collectors being coupled to the collector of the other of the transistors of the additional pair (122) of the output stage (104).

3. A variable gain amplifier (300) for amplifying an input voltage (318) and providing an amplified output voltage (336), comprising:
an input stage (302) that includes two differential transistor pairs (306, 308), the input stage (302) being coupled to an input (318) of the amplifier (300);
an output stage (304) that includes a transistor quad (320) and an additional pair of transistors (322), the output stage (304) being coupled to an output (380) of the amplifier (300), and the transistor quad (320) including terminals to receive a gain control signal (338);
an output of a first (306) of the differential transistor pairs of the input stage (302) being coupled to an input of the output stage quad (320) to provide a variable gain path (142), controllable by the gain control signal (338), between the amplifier input (318) and the amplifier output (336); and
an output of the second (308) of the differential transistor pairs of the input stage (302) being coupled to an input of the additional transistor pair (322) to provide a fixed gain path (140) between the amplifier input (318) and the amplifier output (380), the fixed gain path (140) having a gain that is independent of the gain control signal (338),
wherein:
the transistors are field effect devices; and
and the transistors of the additional pair of transistors (322) of the output stage (304) has a source coupled to a drain of a respective one of the second of the differential transistor pairs of the input stage (302).

4. The variable gain amplifier (300) claim 3 wherein the transistors are field effect devices, and the drains of the transistor quad (320) of the output stage (304) are coupled together in pairs, one coupled pair of drains being coupled to the drain of one of the transistors of the additional pair (322) of the output stage (304), the other coupled pair of drains being coupled to the drain of the other of the transistors of the additional pair (322) of the output stage (304).

5. The variable gain amplifier (100A, 300) of any of the preceding claims, wherein the amplifier input (118, 318) is coupled to a control terminal of each of the transistors of the second (108, 308) of the differential transistor pairs of the input stage (102, 302).

6. The variable gain amplifier (100A, 300) of claim 5, wherein a control terminal of one of the transistors of the first (106, 306) of the differential transistor pairs of the input stage (102, 302) is coupled to a control terminal of one of the transistors of the second (108, 308) of the differential transistor pairs of the input stage (102, 302), and a control terminal of the other of the transistors of the first of the differential transistor pairs of the input stage (102, 302) is coupled to a control terminal of the other of the transistors of the second of the differential transistor pairs of the input stage (102, 302).

7. The variable gain amplifier (100A, 300) of any one of the preceding claims, wherein a first current terminal of one of the transistors of the first (106, 306) of the differential transistor pairs of the input stage (102, 302) is coupled through a first pair of resistance elements (144) to a first current terminal of the other of the transistors of the first of the differential transistor pairs of the input stage (102, 302).

8. The variable gain amplifier (100A, 300) of any one of the preceding claims, wherein a first current terminal of one of the transistors of the second of the differential transistor pairs of the input stage (102, 302) is coupled through a second pair of resistance elements (146) to a first current terminal of the other of the transistors of the second of the differential transistor pairs of the input stage (102, 302).

9. The variable gain amplifier (100A, 300) of claim 7 or claim 8, wherein a current source (148, 340) is connected to a node whereto an end of each of the resistance elements of each pair of resistance elements, respectively, is connected.

10. The variable gain amplifier (100A, 300) of any one of the preceding claims, wherein a bias voltage (150, 342) is arranged to be applied across control terminals of the additional pairs of transistors (122, 322) of the output stage (104, 304).

11. A method (400) of controlling the gain of a variable gain amplifier, performed by the variable gain amplifier (100A, 300) of any of the preceding claims, the variable gain amplifier having a pair of input terminals to receive a signal (118, 318) to be amplified and a pair of output terminals to supply an amplified output signal (136, 336), the method (400) comprising:
supplying an input signal (118, 318) across the pair of input terminals of an input stage (102, 302) of the variable gain amplifier (100A, 300),
amplifying the input signal (118, 318) using a fixed gain amplifying path (140) between the pair of input terminals and the pair of output terminals to provide a fixed gain component of the amplified output signal (136, 336) at the pair of output terminals;
amplifying the input signal (118, 318) using a variable gain amplifying path (142) between the pair of input terminals and the pair of output terminals to provide a variable gain component of the amplified output signal (136, 336) at the pair of output terminals (180, 380); and
applying varying gain control signals to an output stage (104, 304) of the variable gain amplifier (100A, 300) to vary the gain of the variable gain path (142) to control the size of the amplified output signal (136, 336).

## Patentansprüche

1. Verstärker mit variabler Verstärkung (100A) zum Verstärken einer Eingangsspannung (118) und Bereitstellen einer verstärkten Ausgangsspannung (136), umfassend:
eine Eingangsstufe (102), die zwei Differenztransistorpaare (106, 108) beinhaltet, wobei die Eingangsstufe (102) mit einem Eingang (118) des Verstärkers (100A) gekoppelt ist;
eine Ausgangsstufe (104), die einen Transistor-Quad (120) und ein zusätzliches Transistorpaar (122) beinhaltet, wobei die Ausgangsstufe (104) mit einem Ausgang (180) des Verstärkers (100A) gekoppelt ist und der Transistor-Quad (120) Endgeräte zum Empfangen eines Verstärkungssteuersignals (138) beinhaltet;
einen Ausgang eines ersten (106) der Differenztransistorpaare der Eingangsstufe (102), der mit einem Eingang des Ausgangsstufen-Quads (120) gekoppelt ist, um einen variablen Verstärkungspfad (142), der durch das Verstärkungssteuersignal (138) steuerbar ist, zwischen dem Verstärkereingang (118) und dem Verstärkerausgang (136) bereitzustellen; und
einen Ausgang des zweiten (108) der Differenztransistorpaare der Eingangsstufe (102), der mit einem Eingang des zusätzlichen Transistorpaares (122) gekoppelt ist, um einen festen Verstärkungspfad (140) zwischen dem Verstärkereingang (118) und dem Verstärkerausgang (180) bereitzustellen, wobei der feste Verstärkungspfad (140) eine Verstärkung aufweist, die unabhängig von dem Verstärkungssteuersignal (138) ist,
wobei:
die Transistoren bipolare Vorrichtungen sind; und
die Transistoren des zusätzlichen Transistorpaares (122) der Ausgangsstufe (104) einen Emitter aufweisen, der mit einem Kollektor eines jeweiligen des zweiten der Differenztransistorpaare der Eingangsstufe (102) gekoppelt ist.

2. Verstärker mit variabler Verstärkung (100A) nach Anspruch 1, wobei die Transistoren bipolare Vorrichtungen sind und die Kollektoren des Transistor-Quads (120) der Ausgangsstufe (104) paarweise miteinander gekoppelt sind, wobei ein gekoppeltes Kollektorpaar mit dem Kollektor eines der Transistoren des zusätzlichen Paares (122) der Ausgangsstufe (104) gekoppelt ist und das andere gekoppelte Kollektorpaar mit dem Kollektor des anderen der Transistoren des zusätzlichen Paares (122) der Ausgangsstufe (104) gekoppelt ist.

3. Verstärker mit variabler Verstärkung (300) zum Verstärken einer Eingangsspannung (318) und Bereitstellen einer verstärkten Ausgangsspannung (336), umfassend:
eine Eingangsstufe (302), die zwei Differenztransistorpaare (306, 308) beinhaltet, wobei die Eingangsstufe (302) mit einem Eingang (318) des Verstärkers (300) gekoppelt ist;
eine Ausgangsstufe (304), die einen Transistor-Quad (320) und ein zusätzliches Transistorpaar (322) beinhaltet, wobei die Ausgangsstufe (304) mit einem Ausgang (380) des Verstärkers (300) gekoppelt ist und der Transistor-Quad (320) Endgeräte zum Empfangen eines Verstärkungssteuersignals (338) beinhaltet;
einen Ausgang eines ersten (306) der Differenztransistorpaare der Eingangsstufe (302), der mit einem Eingang des Ausgangsstufen-Quads (320) gekoppelt ist, um einen variablen Verstärkungspfad (142), der durch das Verstärkungssteuersignal (338) steuerbar ist, zwischen dem Verstärkereingang (318) und dem Verstärkerausgang (336) bereitzustellen; und
einen Ausgang des zweiten (308) der Differenztransistorpaare der Eingangsstufe (302), der mit einem Eingang des zusätzlichen Transistorpaares (322) gekoppelt ist, um einen festen Verstärkungspfad (140) zwischen dem Verstärkereingang (318) und dem Verstärkerausgang (380) bereitzustellen, wobei der feste Verstärkungspfad (140) eine Verstärkung aufweist, die unabhängig von dem Verstärkungssteuersignal (338) ist,
wobei:
die Transistoren Feldeffektvorrichtungen sind; und
die Transistoren des zusätzlichen Transistorpaares (322) der Ausgangsstufe (304) eine Source aufweisen, die mit einem Drain eines jeweiligen des zweiten der Differenztransistorpaare der Eingangsstufe (302) gekoppelt ist.

4. Verstärker mit variabler Verstärkung (300) nach Anspruch 3, wobei die Transistoren Feldeffektvorrichtungen sind und die Drains des Transistor-Quads (320) der Ausgangsstufe (304) paarweise miteinander gekoppelt sind, wobei ein gekoppeltes Drainpaar mit dem Drain eines der Transistoren des zusätzlichen Paares (322) der Ausgangsstufe (304) gekoppelt ist und das andere gekoppelte Drainpaar mit dem Drain des anderen der Transistoren des zusätzlichen Paares (322) der Ausgangsstufe (304) gekoppelt ist.

5. Verstärker mit variabler Verstärkung (100A, 300) nach einem der vorhergehenden Ansprüche, wobei der Verstärkereingang (118, 318) mit einem Steueranschluss jedes der Transistoren des zweiten (108, 308) der Differenztransistorpaare der Eingangsstufe (102, 302) gekoppelt ist.

6. Verstärker mit variabler Verstärkung (100A, 300) nach Anspruch 5, wobei ein Steueranschluss eines der Transistoren des ersten (106, 306) der Differenztransistorpaare der Eingangsstufe (102, 302) mit einem Steueranschluss eines der Transistoren des zweiten (108, 308) der Differenztransistorpaare der Eingangsstufe (102, 302) gekoppelt ist und ein Steueranschluss des anderen der Transistoren des ersten der Differenztransistorpaare der Eingangsstufe (102, 302) mit einem Steueranschluss des anderen der Transistoren des zweiten der Differenztransistorpaare der Eingangsstufe (102, 302) gekoppelt ist.

7. Verstärker mit variabler Verstärkung (100A, 300) nach einem der vorhergehenden Ansprüche, wobei ein erster Stromanschluss eines der Transistoren des ersten (106, 306) der Differenztransistorpaare der Eingangsstufe (102, 302) über ein erstes Paar von Widerstandselementen (144) mit einem ersten Stromanschluss des anderen der Transistoren des ersten der Differenztransistorpaare der Eingangsstufe (102, 302) gekoppelt ist.

8. Verstärker mit variabler Verstärkung (100A, 300) nach einem der vorhergehenden Ansprüche, wobei ein erster Stromanschluss eines der Transistoren des zweiten der Differenztransistorpaare der Eingangsstufe (102, 302) über ein zweites Paar von Widerstandselementen (146) mit einem ersten Stromanschluss des anderen der Transistoren des zweiten der Differenztransistorpaare der Eingangsstufe (102, 302) gekoppelt ist.

9. Verstärker mit variabler Verstärkung (100A, 300) nach Anspruch 7 oder 8, wobei eine Stromquelle (148, 340) mit einem Knoten verbunden ist, mit dem jeweils ein Ende eines jeden der Widerstandselemente eines jeden Widerstandselementpaares verbunden ist.

10. Verstärker mit variabler Verstärkung (100A, 300) nach einem der vorhergehenden Ansprüche, wobei eine Vorspannung (150, 342) dazu eingerichtet ist, über Steueranschlüsse der zusätzlichen Transistorpaare (122, 322) der Ausgangsstufe (104, 304) angelegt zu werden.

11. Verfahren (400) zum Steuern der Verstärkung eines Verstärkers mit variabler Verstärkung, durchgeführt durch den Verstärker mit variabler Verstärkung (100A, 300) nach einem der vorhergehenden Ansprüche, wobei der Verstärker mit variabler Verstärkung ein Eingangsanschlusspaar zum Empfangen eines zu verstärkenden Signals (118, 318) und ein Ausgangsanschlusspaar zum Ausgeben eines verstärkten Ausgangssignals (136, 336) aufweist, wobei das Verfahren (400) Folgendes umfasst:
Ausgeben eines Eingangssignals (118, 318) über das Eingangsanschlusspaar einer Eingangsstufe (102, 302) des Verstärkers mit variabler Verstärkung (100A, 300),
Verstärken des Eingangssignals (118, 318) unter Verwendung eines Verstärkungspfads mit fester Verstärkung (140) zwischen dem Eingangsanschlusspaar und dem Ausgangsanschlusspaar, um eine Komponente mit fester Verstärkung des verstärkten Ausgangssignals (136, 336) an dem Ausgangsanschlusspaar bereitzustellen;
Verstärken des Eingangssignals (118, 318) unter Verwendung eines Verstärkungspfads mit variabler Verstärkung (142) zwischen dem Eingangsanschlusspaar und dem Ausgangsanschlusspaar, um eine Komponente mit variabler Verstärkung des verstärkten Ausgangssignals (136, 336) an dem Ausgangsanschlusspaar (180, 380) bereitzustellen; und
Anlegen variierender Verstärkungssteuersignale an eine Ausgangsstufe (104, 304) des Verstärkers mit variabler Verstärkung (100A, 300), um die Verstärkung des variablen Verstärkungspfads (142) zu variieren, um die Größe des verstärkten Ausgangssignals (136, 336) zu steuern.

## Revendications

1. Amplificateur à gain variable (100A) destiné à amplifier une tension d'entrée (118) et à fournir une tension de sortie amplifiée (136), comprenant :
un étage d'entrée (102) qui comporte deux paires de transistors différentiels (106, 108), l'étage d'entrée (102) étant couplé à une entrée (118) de l'amplificateur (100A) ;
un étage de sortie (104) qui comporte un quadruplet de transistors (120) et une paire supplémentaire de transistors (122), l'étage de sortie (104) étant couplé à une sortie (180) de l'amplificateur (100A), et le quadruplet de transistors (120) comportant des bornes pour recevoir un signal de commande de gain (138) ;
une sortie d'une première (106) paire de transistors différentiels de l'étage d'entrée (102) étant couplée à une entrée du quadruplet de l'étage de sortie (120) pour fournir un chemin de gain variable (142), contrôlable par le signal de commande de gain (138), entre l'entrée de l'amplificateur (118) et la sortie de l'amplificateur (136) ; et
une sortie de la seconde (108) des paires de transistors différentiels de l'étage d'entrée (102) étant couplée à une entrée de la paire de transistors supplémentaire (122) pour fournir un chemin de gain fixe (140) entre l'entrée de l'amplificateur (118) et la sortie de l'amplificateur (180), le chemin de gain fixe (140) ayant un gain indépendant du signal de commande de gain (138),
dans lequel :
les transistors sont des dispositifs bipolaires ; et
les transistors de la paire supplémentaire de transistors (122) de l'étage de sortie (104) ont un émetteur couplé à un collecteur de l'une des secondes des paires respectives de transistors différentiels de l'étage d'entrée (102).

2. Amplificateur à gain variable (100A) selon la revendication 1, dans lequel les transistors sont des dispositifs bipolaires, et les collecteurs du quadruplet de transistors (120) de l'étage de sortie (104) sont couplés par paires, une paire de collecteurs couplés étant couplée au collecteur de l'un des transistors de la paire supplémentaire (122) de l'étage de sortie (104), l'autre paire de collecteurs couplés étant couplée au collecteur de l'autre des transistors de la paire supplémentaire (122) de l'étage de sortie (104).

3. Amplificateur à gain variable (300) destiné à amplifier une tension d'entrée (318) et à fournir une tension de sortie amplifiée (336), comprenant :
un étage d'entrée (302) qui comporte deux paires de transistors différentiels (306, 308), l'étage d'entrée (302) étant couplé à une entrée (318) de l'amplificateur (300) ;
un étage de sortie (304) qui comporte un quadruplet de transistors (320) et une paire supplémentaire de transistors (322), l'étage de sortie (304) étant couplé à une sortie (380) de l'amplificateur (300), et le quadruplet de transistors (320) comportant des bornes pour recevoir un signal de commande de gain (338) ;
une sortie d'une première (306) paire de transistors différentiels de l'étage d'entrée (302) étant couplée à une entrée du quadruplet de l'étage de sortie (320) pour fournir un chemin de gain variable (142), contrôlable par le signal de commande de gain (338), entre l'entrée de l'amplificateur (318) et la sortie de l'amplificateur (336) ; et
une sortie de la seconde (308) des paires de transistors différentiels de l'étage d'entrée (302) étant couplée à une entrée de la paire de transistors supplémentaire (322) pour fournir un chemin de gain fixe (140) entre l'entrée de l'amplificateur (318) et la sortie de l'amplificateur (380), le chemin de gain fixe (140) ayant un gain indépendant du signal de commande de gain (338),
dans lequel :
les transistors sont des dispositifs à effet de champ ; et
les transistors de la paire supplémentaire de transistors (322) de l'étage de sortie (304) ont une source couplée à un drain de l'une des secondes des paires respectives de transistors différentiels de l'étage d'entrée (302).

4. Amplificateur à gain variable (300) selon la revendication 3, dans lequel les transistors sont des dispositifs à effet de champ, et les drains du quadruplet de transistors (320) de l'étage de sortie (304) sont couplés par paires, une paire de drains couplés étant couplée au drain de l'un des transistors de la paire supplémentaire (322) de l'étage de sortie (304), l'autre paire de drains couplés étant couplée au drain de l'autre des transistors de la paire supplémentaire (322) de l'étage de sortie (304).

5. Amplificateur à gain variable (100A, 300) selon l'une quelconque des revendications précédentes, dans lequel l'entrée de l'amplificateur (118, 318) est couplée à une borne de commande de chacun des transistors de la seconde (108, 308) des paires de transistors différentiels de l'étage d'entrée (102, 302).

6. Amplificateur à gain variable (100A, 300) selon la revendication 5, dans lequel une borne de commande de l'un des transistors de la première (106, 306) des paires de transistors différentiels de l'étage d'entrée (102, 302) est couplée à une borne de commande de l'un des transistors de la seconde (108, 308) des paires de transistors différentiels de l'étage d'entrée (102, 302), et une borne de commande de l'autre des transistors de la première paire de transistors différentiels de l'étage d'entrée (102, 302) est couplée à une borne de commande de l'autre des transistors de la seconde paire des transistors différentiels de l'étage d'entrée (102, 302).

7. Amplificateur à gain variable (100A, 300) selon l'une quelconque des revendications précédentes, dans lequel une première borne de courant de l'un des transistors de la première (106, 306) des paires de transistors différentiels de l'étage d'entrée (102, 302) est couplée par l'intermédiaire d'une première paire d'éléments de résistance (144) à une première borne de courant de l'autre des transistors de la première des paires de transistors différentiels de l'étage d'entrée (102, 302).

8. Amplificateur à gain variable (100A, 300) selon l'une quelconque des revendications précédentes, dans lequel une première borne de courant de l'un des transistors de la seconde des paires de transistors différentiels de l'étage d'entrée (102, 302) est couplée par l'intermédiaire d'une seconde paire d'éléments de résistance (146) à une première borne de courant de l'autre des transistors de la seconde des paires de transistors différentiels de l'étage d'entrée (102, 302).

9. Amplificateur à gain variable (100A, 300) selon la revendication 7 ou la revendication 8, dans lequel une source de courant (148, 340) est connectée à un nœud auquel est connectée une extrémité de chacun des éléments de résistance de chaque paire d'éléments de résistance, respectivement.

10. Amplificateur à gain variable (100A, 300) selon l'une quelconque des revendications précédentes, dans lequel une tension de polarisation (150, 342) est disposée pour être appliquée aux bornes de commande des paires supplémentaires de transistors (122, 322) de l'étage de sortie (104, 304).

11. Procédé (400) de commande du gain d'un amplificateur à gain variable, réalisé par l'amplificateur à gain variable (100A, 300) selon l'une quelconque des revendications précédentes, l'amplificateur à gain variable comportant une paire de bornes d'entrée pour recevoir un signal (118, 318) à amplifier et une paire de bornes de sortie pour fournir un signal de sortie amplifié (136, 336), le procédé (400) comprenant :
la fourniture d'un signal d'entrée (118, 318) à la paire de bornes d'entrée d'un étage d'entrée (102, 302) de l'amplificateur à gain variable (100A, 300),
l'amplification du signal d'entrée (118, 318) en utilisant un chemin d'amplification à gain fixe (140) entre la paire de bornes d'entrée et la paire de bornes de sortie pour fournir une composante de gain fixe du signal de sortie amplifié (136, 336) à la paire de bornes de sortie ;
l'amplification du signal d'entrée (118, 318) en utilisant un chemin d'amplification à gain variable (142) entre la paire de bornes d'entrée et la paire de bornes de sortie pour fournir une composante de gain variable du signal de sortie amplifié (136, 336) à la paire de bornes de sortie (180, 380) ; et
l'application de signaux de commande de gain variable à un étage de sortie (104, 304) de l'amplificateur à gain variable (100A, 300) pour faire varier le gain du chemin à gain variable (142) afin de régler l'amplitude du signal de sortie amplifié (136, 336).
